# EUROPEAN PATENT APPLICATION

(11) **EP 2 308 632 A1**
(43) Date of publication of application: **13.04.2011**
(21) Application number: 10008336.9
(22) Date of filing: 10.08.2010
(51) Int. Cl.: B23K 20/00, B23K 35/38, C01B 3/02, C01B 3/50, C01B 21/02, C01B 21/04, H01L 21/00, H01L 21/60

(54) **Method of and device for wire bonding with on-site gas generator**

(30) Priority: 08.10.2009 MY 0904226; 10.12.2009 EP 09015277
(71) Applicant: Linde Aktiengesellschaft, 80331 München (DE)
(72) Inventor: Laumen, Christoph, 80634 München (DE); Hiew, Pang Ling, off Jalan Klang Lama (MY)

(57) **Abstract**

The present invention relates to a device for wire bonding comprising a guidance for a bond wire and a melt inducing device for melting the surface of a definite region of the bond wire surface, whereby the bond wire guidance is adapted to guide the definite region of the bond wire into a bonding area (1) and connect it to at least one bond pad, whereby the bonding area (1) comprises a process gas inlet (3), wherein the process gas inlet (3) is connected to an on-site gas generator (5) which generates the process gas. In addition, the present invention relates to a method of wire bonding comprising the steps of: connecting a definite region of a guided bond wire to a bond pad, whereby the surface of the definite region is previously melted and the whole process takes place within a bonding area (1), which contains a process gas, which is led into the bonding area prior or during the bonding process, wherein at least a part of the process gas is generated by an on-site gas generator (5).

## Description

The present invention relates to a device for wire bonding comprising a guidance for a bond wire and a melt inducing device for melting the surface of a definite region of the bond wire surface, whereby the bond wire guidance is adapted to guide the definite region of the bond wire into a bonding area and connect it to at least one bond pad, wherein the bonding area comprises a process gas inlet. Furthermore the present invention relates to a method for wire bonding comprising the steps of connecting a definite region of a bond wire to a bond pad, whereby the surface of the definite region is previously melted and the whole process takes place within a bonding area which contains a process gas which is led into the bonding area prior to or during the bonding process.

Wire bonding is a known production process in the electronics industry used to connect electronic parts, especially parts of microelectronics. Also micro sized non-electronic parts can be connected by this method. The wires used are commonly of a very thin diameter and are called bond wires. Wire bonding is used to connect two or more parts with such a wire. Each part has at least one contact site which is usually called a bond pad. The parts can be a metal or metallized part of a microcircuit, for example, or any chip module or other electronic part.

The use of process gases is widely known for improving the results of the wire bonding process. There are a couple of gases and gas mixtures that proved to be especially useful, for example nitrogen, a mixture of hydrogen and nitrogen and/or argon, helium or others.

With the known wire bonding methods usually a gold wire or a gold alloy wire is used. It is also known to use aluminium or copper wire.

When using a copper wire or a copper or copper alloy containing wire difficulties are known concerning adhesive oxides. Copper is known to be at least slightly oxidized. The conductivity of an oxidized copper containing wire, ease of bonding and the joint strength are reduced by the presence of oxides on the surface of the copper containing wire. All above-mentioned possibilities of copper or copper (alloy) containing wire shall be referred to as copper containing wire in the following and shall cover pure copper wire as well as copper containing wire containing at least 10% of pure copper.

Document US 6,234,376 discloses a method and a device for wire bonding using a process gas in order to reduce the formation of oxides and therefore to improve the usability of copper or aluminium bonding wire.

The object of the present invention is to improve the supply of the process gas.

This object is achieved by providing a device for wire bonding comprising a guidance for a bond wire and a melt inducing device for melting the surface of a definite region of the bond wire surface, whereby the bond wire guidance is adapted to guide the definite region of the bond wire into a bonding area and connect it to at least one bond pad, wherein the bonding area comprises a process gas inlet and which is **characterized in that** the process gas inlet is connected to an on-site gas generator which generates a process gas.

In the following a device for wire bonding is also called a wire bonder.

The term "process gas" shall in particular mean inert gases, such as nitrogen, argon or helium, and active gases, such as hydrogen, which are reactive with the surfaces of the bond wire and/or the bond pad.

The term "bonding area" shall mean an area where the bonding process is carried out. In particular the bonding area is designed as a closed bonding room. But the bonding area could also be a volume which is partly or totally open to the surroundings.

According to the invention at least a portion of the process gas is generated on-site, that is close to the point of use. This solution offers the advantage of being able to make any gas reservoir obsolete. For example an on-site nitrogen generator can provide an inert atmosphere inside the bonding area, e.g. a nitrogen generation unit comprising a PSA (pressure swing adsorption) or a membrane. According to another example, a hydrogen generator could be used, e.g. a generator of the electrolytic, ammonia cracking or the hydrocarbon reforming type. The hydrogen generated can be used as the process gas for the device for wire bonding alone or can be mixed with another gas.

Wire bonders are relative small machines and thus the volume of the bonding area is also relative small. The amount of gas which is required during the bonding process is typically in the range of some 10 liters per hour (I/h) at standard temperature and pressure (STP). Therefore, according to a preferred embodiment the on-site generator is designed to produce less than 1000 l/h of the process gas, preferably less than 500 l/h of the process gas, more preferred less than 200 l/h of the process gas at standard conditions (STP).

According to an embodiment of the present invention the gas generator is connected to the inlet via a first pipe. The gas generator is preferably used to prduce an inert gas, especially nitrogen, and/or an active process gas, for example a process gas which can be activated in a plasma, especially hydrogen.

According to a favorable embodiment of the present invention a second pipe is connected to the first pipe or to another inlet to the bonding area and to a gas reservoir. Thus, the second pipe connects a gas reservoir with the device for wire bonding. The gas reservoir could be used to supply an inert gas to the wire bonder, especially to the bonding area. The gas reservoir could also be used to store a process gas which reacts with the bond wire, with the bond pad, with substances, particles or gases present on or in the close proximity to the surfaces of the bond wire or the bond pad. This embodiment is favored because of the opportunity to combine a process gas mixture for example nitrogen supplied by the gas reservoir with hydrogen generated by the on-site gas generator. Such a hydrogen generator might be supplied with water, NH₃ and/or hydrocarbons.

Preferably the wire bonder is supplied with nitrogen and hydrogen, at least one of these gases produced on-site. For example a mixture of nitrogen and hydrogen containing 3% to 100% hydrogen is used, preferably a mixture of nitrogen and hydrogen containing 3% to 20% hydrogen, more preferred 5% to 10% hydrogen, is used.

According to another embodiment of the present invention the first pipe is connected to the second pipe at a connection point upstream of the process gas inlet of the bonding area. Therefore, preferably only one inlet is necessary for introducing the process gas or the process gases into the bonding area.

According to another embodiment of the present invention a mixer is located at the connection point. The use of this mixer enables to provide predetermined percentages of each component of a process gas mixture. For example the percentage of hydrogen in a gas mixture of nitrogen and hydrogen determines the reducing effect of the process gas mixture and is therefore a preferred object of predetermination. For example the mixer can be used to mix generated hydrogen with nitrogen supplied from a nitrogen gas reservoir.

According to another embodiment of the present invention a deoxopurifier is connected to the first and/or second pipe upstream of the process gas inlet of the bonding area, enabling the control of the oxygen content of the process gas and/or of components of the process gas. For example a catalytic deoxopurifier can be used.

According to another embodiment of the present invention a second gas generator is provided. This second gas generator is a nitrogen generator, for example. According to this embodiment the second gas generator can make obsolete any gas reservoir. For example a combination of two on-site gas generators, one hydrogen generator and one nitrogen generator, is very favorable. However, it is also possible to use two on-site gas generators and one or more gas reservoirs if more than two process gases are needed in the wire bonder.

The object of the present invention is also solved by a method for wire bonding comprising the step of generating at least a part of the process gas by an on-site gas generator.

According to another embodiment the process gas is mixed with a second gas supplied by a gas reservoir or generated by a second on-site gas generator and is afterwards introduced into the bonding area.

According to another embodiment a deoxopurifier is used somewhere upstream the inlet to the bonding area to remove at least a part of the oxygen content of the process gas or of components of the process gas.

According to another embodiment of the present invention the gas generator(s) can be used for supplying multiple bonding devices with process gas. The typical process gas consumption of a wire bonder is in the range 20 to 100 l/h (STP). Thus, an on-site gas generator for an inventive wire bonder supplies preferably less than 200 l/h process gas at standard temperature and pressure conditions if the on-site generator does supply one wire bonder only. If the gas generator shall supply multiple devices for wire bonding with a process gas the production rate of the on-site gas generator has to be adapted. In that case the gas generator produces for example between 200 l/h and 500 l/h of the process gas or between 300 l/h and 1000 l/h of the process gas.

The invention is in particular useful for bonding a bond wire to a bond pad wherein at least one of them is made of copper or a copper alloy. The term "made of copper" shall mean that the bond wire and/or the bond pad contain pure copper or a copper alloy with a copper content of at least 10%.

According to a preferred embodiment hydrogen is produced on-site by the gas generator and then supplied to plasma generating merans, such as a plasma torch, in the wire bonder. The plasma generating means generate a plasma which is preferably used to produce a reducing atmosphere in the bonding area.

The present invention shows a lot of advantages. Among others there is to mention the improved safety of the device and method by omitting a hydrogen reservoir. The users of a wire bonding machine do no longer need to handle hydrogen or hydrogen containing mixtures which are potentially flammable and explosive. Furthermore, no storage, movement or piping covering longer distances of hydrogen or hydrogen containing gas mixtures is needed which leads to a reduced need of space, handling, administration and safety efforts, for example concerning leakage. Also, as always in connection with on-site equipment, there is the advantage of reducing delivery needs and connected energy consumption. The on-site gas generation allows to produce the needed amount even in small quantities.

The invention as well as further details and preferred embodiments of the invention are disclosed in the following description and in the accompanying figures. The figures show schematic drawings of the bonding area as point of use and the supply for process gas to the bonding area of the wire bonding device:
- Figure 1: shows the state of the art with a gas reservoir supplying the bonding area with a process gas,
- Figure 2: shows an inventive device comprising a bonding area and an on-site gas generator,
- Figure 3: shows an inventive device comprising a bonding area and an on-site gas generator as well as a gas reservoir,
- Figure 4: shows an inventive device comprising a bonding area, an on-site gas generator, a gas reservoir and a mixer,
- Figure 5: shows an inventive device comprising a bonding area, an on-site gas generator, a gas reservoir and a deoxopurifier,
- Figure 6: shows an inventive device comprising a bonding area and two on-site gas generators as well as a deoxopurifier and
- Figure 7: shows an inventive device comprising a bonding area, an on-site gas generator and a gas reservoir without a mixer,
- Figure 8: shows another preferred embodiment of the invention.

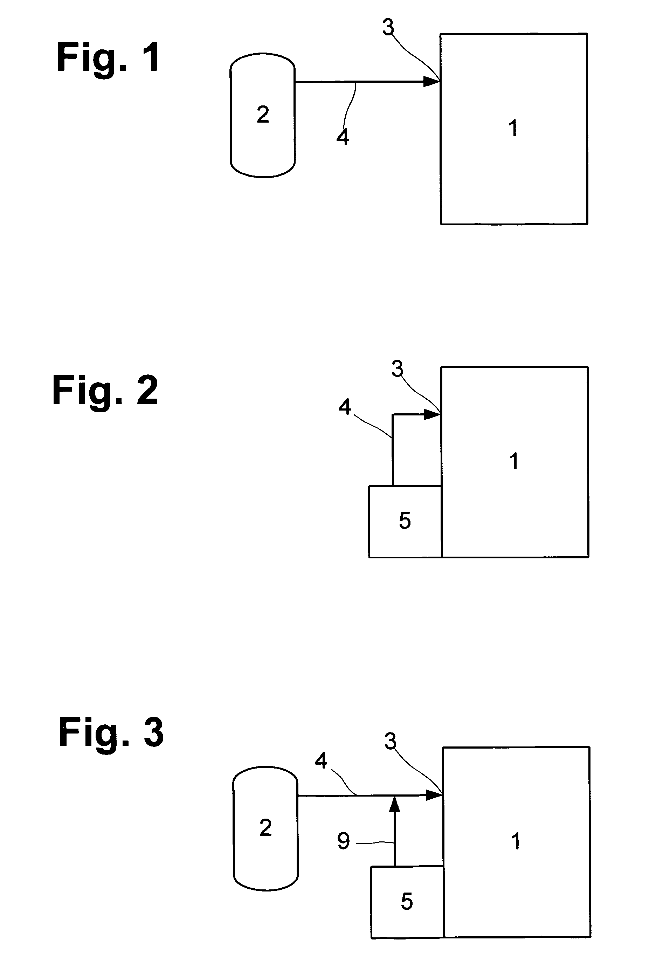

In detail, figure 1 shows the state of the art with a bonding device comprising a bonding area 1 which is supplied by a process gas taken from a gas reservoir 2 containing for example a mixture of hydrogen and nitrogen or containing pure hydrogen as an alternative.

According to the invention at least one component of the process gas or process gas mixture is produced on-site rather than being supplied from a gas storage. The process gas or process gas mixture is supplied to the bonding device either directly into the bonding area or to any means within the bonding device which utilise the process gas.

Figure 2 shows a device for wire bonding according to the invention with a bonding area 1 and an on-site gas generator 5 connected to the inlet 3 to the bonding area 1 via a pipe 4. This example is preferred to provide a pure hydrogen process gas to the bonding area 1 enabling the protection from oxide built-up on the bonding wire and/or bond pad. For example water, NH₃ or hydrocarbons can be fed to the hydrogen generator 5 as input and hydrogen is generated as output. Thegenerated hydrogen leaves the hydrogen generator 5 and is fed into the bonding area 1 via pipe 4.

The invention thus provides a safe and easy to handle wire bonding system. The user does not have to handle hydrogen or hydrogen containing mixtures which are potentially flammable and explosive. Since there is no need for storage of hydrogen the chances of leakage are essentially reduced thus improving safety.

According to another preferred embodiment of the invention at least one component of a process gas mixture is generated on-site and at least one other component of the process gas mixture is supplied from a gas storage device or gas reservoir. These gas streams can be directed to the bonding area as separate gas streams without any premixing or two or more of the gas streams can be premixed and then directed to the bonding area.

Figure 3 shows such an embodiment comprising a bonding area 1 and an on-site gas generator 5 as well as a gas reservoir 2. For example water, NH₃ or hydrocarbons are fed to the hydrogen generator 5. Generated hydrogen leaves the hydrogen generator 5 and is fed into the bonding area 1 via pipe 9 and pipe 4. Pipe 4 is connected to a gas reservoir 2 and ends at the inlet 3 to the bonding area 1. Therefore, generated gas, for example hydrogen, is first mixed with a gas from a gas reservoir, for example nitrogen, and then the hydrogen-nitrogen-mixture is fed into the bonding area 1 via pipe 4.

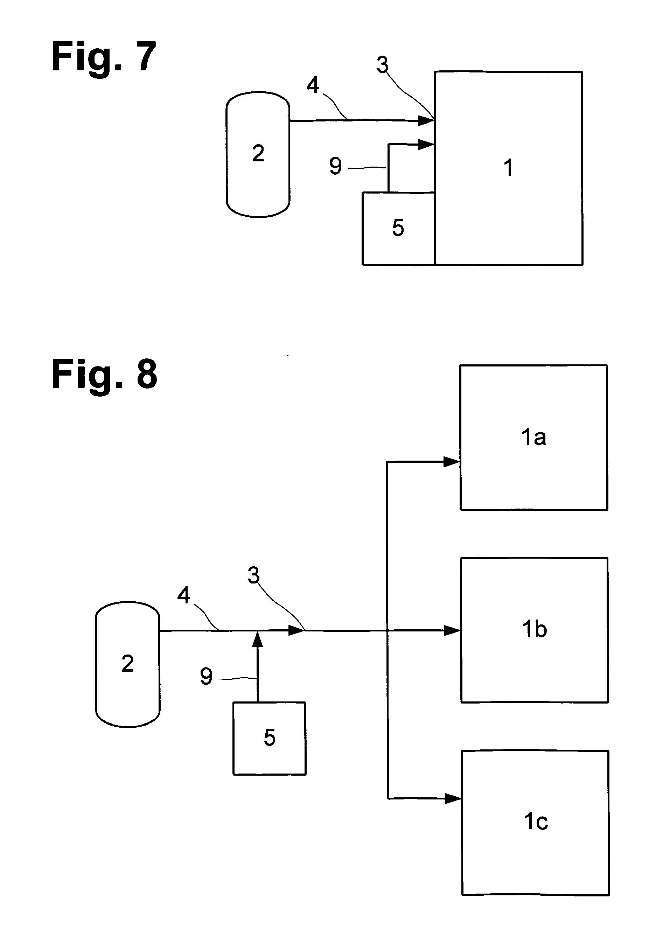

In figure 7 a system without premixing the generated gas stream 9 and the gas 4 withdrawn from the gas reservoir 2 is shown. This is in particular advantageous when the different process gas streams 4, 9 shall be directed to different areas of the bonding area 1 or when one or both of them are not directly introduced into the bonding area 1 but first fed to sub-devices, for example a plasma generating device, within the bonding device.

It is further possible to feed a first part of one the streams 4, 9 as a pure stream containing only one process gas into the bonding area 1 and to miox the remainder of this gas stream with another process gas before feeding into the bonding area 1. For example, nitrogen may be supplied from a gas reservoir and, for inerting purposes, part fo the nitrogen is fed as a pure gas into the bonding area. Another part of the nitrogen is mixed with hydrogen which has been produced on-site according to the invention. That hydrogen-nitrogen mixture is separately fed to the bonding area and used as a plasma gas for generating a plasma at for example a local spot within the bonding area.

It is also possible to use process gas mixtures with three or more components. The single components can either be produced on-site by a generator or supplied from a gas storage. It is also possible to produce one component on-site and to have the other components as a gas mixture stored in a gas reservoir.

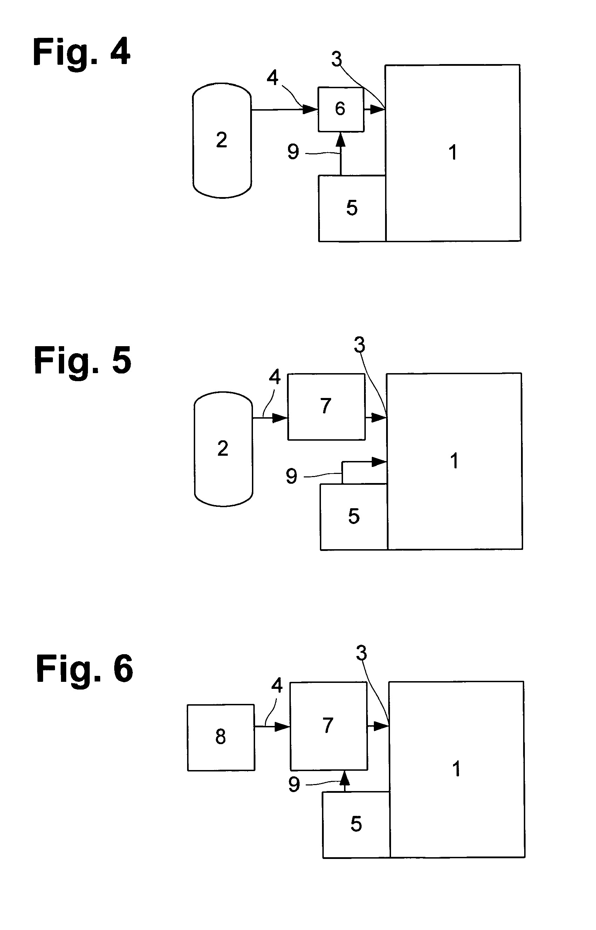

Figure 4 shows an inventive device comprising a bonding area 1, an on-site gas generator 5, a gas reservoir 2 and a mixer 6. Except of the mixer 6, all other components shown in figure 4 are the same as in figure 3. At the connection point of pipe 4 and pipe 9 a mixer 6 is integrated and used to improve the mixing of the two gases supplied by the two pipes 4 and 9. The capacity of the gas generator 5 is preferably adjustable. Thus, by mixing a base gas such as nitrogen supplied from the gas reservoir 2 with hydrogen produced by the gas generator 5 it is possible to produce a process gas mixture with different percentages of hydrogen in the base gas. The hydrogen content of the process gas mixture can be adjusted to the bonding process.

Instead of supplying high purity gases from a gas reservoir to the bonding area it is possible to add a gas purifier to the gas supply system. The gas withdrawn from the gas reservoir is first fed to a gas purifying unit such as a de-oxo purifier in order to purify the gas, for example in order to remove residual oxygen. The purified gas is then fed to the bonding area. As described above the purified gas can be directed to the bonding area as a separate stream or together with the gas stream generated by the gas generator.

Figure 5 shows an example of such a system. The inventive device comprises a bonding area 1, an on-site gas generator 5, a gas reservoir 2 and a de-oxo purifier 7. The use of a de-oxo purifier 7 makes it possible to use a gas reservoir 2 containing low purity gas, for example low purity nitrogen. The de-oxo purifier 7 removes residual oxygen from the low purity nitrogen gas. The purified nitrogen gas is then directed to the bonding area 1.

It is further possible to use the purifier to remove undesired components from the gas produced by the gas generator. According to another preferred embodiment the gas purifier, for example a de-oxo purifier, is used for purifying gas produced by the gas generator as well as the gas supplied from a gas reservoir.

According to another preferred embodiment two or more components of the process gas, preferably all components of the process gas, are produced by one or more gas generators. Figure 6 shows such a device comprising a bonding area 1 and two on-site gas generators 5, 8 as well as a de-oxo purifier 7. Except of the second on-site gas generator 8, all other components shown in figure 6 are the same as in figure 5. The second on-site gas generator 8 is for example a nitrogen generator 8 comprising an outlet pipe 4. At the connection point of pipe 4 and pipe 9 the de-oxo purifier 7 is integrated and intended to clean both gases supplied by pipe 4 and pipe 9. Therefore, a very clean process gas which has been completely generated by on-site gas generators 5, 8 is supplied via pipe 3 into the bonding area 1. A gas reservoir is no longer needed according to this example of the present invention.

Any of the inventive embodiments described above can also be used to supply multiple bonding areas. Figure 8 shows an example of such a system. The system is similar to the one shown in figure 3 but instead of only one bonding area there are 3 bonding areas 1 a, 1 b, 1 c which are supplied with gas from the gas generator 5 and from the gas reservoir 2.

## Claims

1. Device for wire bonding comprising a guidance for a bond wire and a melt inducing device for melting the surface of a definite region of the bond wire surface, whereby the bond wire guidance is adapted to guide the definite region of the bond wire into a bonding area (1) and connect it to at least one bond pad, wherein the bonding area (1) comprises a process gas inlet (3), **characterized in that** the process gas inlet (3) is connected to an on-site gas generator (5) which generates a process gas.

2. Device according to claim 1, further comprising a gas purifier (7), preferably a de-oxo purifier, for purifying the process gas or a part of the process gas (4, 9) prior to being directed into the bonding area (1).

3. Device according to claim 1 or 2, **characterized in that** a second pipe (9) is connected to the same or another process gas inlet (3) to the bonding area (1) and to a gas reservoir (2).

4. Device according to claim 3, **characterized in that** the first pipe (4) is connected to the second pipe (9) at a connection point upstream of the process gas inlet (3) of the bonding area (1).

5. Device according to claim 4, comprising a mixer (6) which is located at the connection point.

6. Device according to claim 4 or 5, **characterized in that** a deoxopurifier (7) is connected to the first and/or second pipe (4, 9) upstream of the process gas inlet (3) of the bonding area (1).

7. Device according to any of claims 1 to 6, comprising a second gas generator (8).

8. Device according to any of claims 1 to 7, **characterized in that** the on-site generator is designed to produce less than 1000 l/h of the process gas, preferably less than 500 l/h of the process gas, more preferred less than 200 l/h of the process gas at standard conditions (STP).

9. Method for wire bonding comprising the steps of: connecting a definite region of a bond wire to a bond pad, whereby the surface of the definite region is previously melted and the whole process takes place within a bonding area (1), which contains a process gas, which is led into the bonding area prior to or during the bonding process, **characterized in that** at least a part of the process gas is generated by an on-site gas generator (5).

10. Method according to claim 9, **characterized in that** the process gas is mixed with a second gas supplied by a gas reservoir (2) or generated by a second on-site gas generator (8) and is afterwards introduced into the bonding area (1).

11. Method according to claim 9 or 10, **characterized in that** a deoxopurifier (7) is used somewhere upstream the inlet (3) to the bonding area to remove at least a part of the oxygen content of the process gas or of components of the process gas.

12. Method according to any of claims 9 to 11 **characterized in that** a hydrogen containing gas is generated by said gas generator (5).

13. Method according to any of claims 9 to 12 **characterized in that** a nitrogen containing gas is generated by said gas generator (5).

14. Method according to any of claims 9 to 13 **characterized in that** said bond wire and/or said bond pad are made of copper.

15. Method according to any of claims 9 to 14 **characterized in that** less than 1000 l/h of the process gas, preferably less than 500 l/h of the process gas, more preferred less than 200 l/h of the process gas at standard conditions (STP) are generated by said on-site gas generator.
